# EUROPEAN PATENT APPLICATION

(11) **EP 0 729 033 A2**
(43) Date of publication of application: **28.08.1996**
(21) Application number: 96102466.8
(22) Date of filing: 19.02.1996
(51) Int. Cl.: G01R 15/20

(54) **Optical current transformer**

(30) Priority: 21.02.1995 JP 32337/95
(71) Applicant: HITACHI, LTD., Chiyoda-ku, Tokyo 101 (JP); THE KANSAI ELECTRIC POWER CO., INC., Osaka 530-70 (JP)
(72) Inventor: Sone, Isamu, Hitachiota-shi (JP); Shirakura, Toshiharu, Naka-gun, Ibaraki-ken (JP); Kawashima, Keizaburo, Hitachi-shi (JP); Hayashida, Hiroshi, Nishinomiya-shi (JP); Nakagama, Yoshiaki, Kobe-shi (JP); Shimizu, Makoto, Ibaraki-shi (JP)
(74) Representative: Strehl Schübel-Hopf Groening & Partner

(57) **Abstract**

An optical current transformer in which an influence of a temperature change in a magneto-optic sensor unit is compensated to conduct measurements with high accuracy by the following structure: Between two polarizers 4 and 5 having mutually different transmission polarized light directions, a Faraday rotator 6 is disposed to form a magneto-optic sensor unit. Light beams from optical transmission units 2 and 2' are inputted to the magneto-optic sensor unit in opposite directions. Two light sources 7 and 7' for emitting the input light beams emit light beams having the same waveform characteristics. Light beams outputted from the magneto-optic sensor unit are converted to electric signals by photoelectric conversion units 8 and 8'. Two light beams traveling through the magneto-optic sensor unit in mutually opposite directions are subjected to intensity modulation by using mutually different frequencies. From the electric signals after photoelectric conversion, intensity-modulated frequency components are selectively extracted. The change of quantity of light caused in two light beams by the Faraday effect is derived by differential computation.

## Description

### BACKGROUND OF THE INVENTION

The present invention relates to optical current transmformers (optical CTs) using the Faraday effect, and in particular to optical current transformers compensated in effect caused by a temperature change in a magneto-optic sensor unit and consequently having a high measurement accuracy.

In optical current transformers using the Faraday effect, it is important to compensate a change of quantity of light generated by a light source and a change of quantity of light in an optical transmission portion such as optical fibers. A conventional technique is described in JP-B-62-35627, Therein, there is proposed a method of inputting light beams to a Faraday rotator in mutually opposite directions by paying attention to non-reciprocal charactristics of the Faraday effect.

As one of detection methods for realizing optical CTs having a high measurement accuracy, the present inventors fabricated by way of experiment and studied optical sensors using the method described in JP-B-62-35627, i.e., the method of inputting light beams to a Faraday rotator in mutually opposite directions. As a result, the following problem was found. When a light beam from the same light source was branched by a half mirror and inputted to a Faraday rotator in mutually opposite directions, measurement accuracy was degraded if the isolation characteristics of the light branching device was insufficient. If light beams respectively supplied from two light sources having mutually different wavelength characteristcs were inputted in mutually opposite directions in order to avoid the above described problem, dependence of the magneto-optic sensor upon wavelength caused an error and the temperature characteristics could not be compensated sufficiently, resulting in a differnt problem.

### SUMMARY OF THE INVENTION

An object of the present invention is to provide an optical current transformer capable of detecting a current with high accuracy irrespective of temperature.

The above described object is achieved by providing, in an optical current transformer using the Faraday effect, a magneto-optic sensor unit having a Faraday rotator disposed between two polarizers having mutually different transmission polarized light directions, optical transmission units for inputting light beams to the magneto-optic sensor unit in mutually opposite directions, light source units for generating the input light beams, photoelectric conversion units for sensing output light beams from the magneto-optic sensor unit, and a signal processing circuit for conducting computation processing on electrical signals subjected to photoelectric conversion, and by using, as the light source units, two light sources providing light beams traveling through the magneto-optic sensor unit in mutually opposite directions with same wavelength characteristics.

The above described object is achieved also by providing, in an optical current transformer using the Faraday effect, a magneto-optic sensor unit having a Faraday rotator disposed between two polarizers having mutually different transmission polarized light directions, optical transmission units for inputting light beams to the magneto-optic sensor unit in mutually opposite directions, light source units for generating the input light beams, photoelectric conversion units for sensing output light beams from the magneto-optic sensor unit, signal processing means for conducting computation processing on electrical signals subjected to photoelectric conversion, means for applying intensity modulation to light beams traveling through the magneto-optic sensor unit in mutually opposite directions by using mutually different frequencies, and extraction means for selectively extracting intensity-modulated frequency components from the electric signals subjected to photoelectric conversion and making the signal processing means conduct computation processing.

The above described object is achieved also by providing, in an optical current transformer using the Faraday effect, a magneto-optic sensor unit having a Faraday rotator disposed between two polarizers having mutually different transmission polarized light directions, optical transmission units for inputting light beams to the magneto-optic sensor unit in mutually opposite directions, light source units for generating the input light beams, photoelectric conversion units for sensing output light beams from the magneto-optic sensor unit, and signal processing means for conducting computation processing on electrical signals subjected to photoelectric conversion, and by providing, in the signal processing means, means for conducting differential computation to derive a change of quantity of light caused by the Faraday effect in two beams traveling through the magneto-optic sensor unit in mutually opposite directions.

Preferably, a Faraday sensor of closed linear integral type is used as the Faraday rotator.

Two light beams having mutually perpendicular linearly polarized light planes are prepared. A CT is configured so that these two light beams will travel through a magneto-optic sensor unit in mutually opposite directions. Even if at this time a change caused in quantity of light by the Faraday effect and a change caused in quantity of light by a temperature change mixedly exist under the state that the magneto-optic sensor unit is subjected to the temperature change, it becomes theoretically possible to cancel the change caused in quantity of light by the temperature change and sense only the change caused in quantity of light by the Faraday effect owing to the non-reciprocal charateristics of the Faraday effect. In order to achieve the above described object concretely, however, it is necessary to make wavelength characteristics of the two light beams traveling in mutually opposite directions identical and improve the separation characteristics of the two beams.

In the present invention, the influence of wavelength characteristics of the magneto-optic sensor unit and optical transmission units are excluded by using two light sources having the same wavelength characteristics. Furthermore, the present invention makes it possible to measure a current with high accuracy by applying intensity modulation to the two light beams with mutually different frequencies, extracting modulating frequency components from electric signals subjected to photoelectric conversion by using extraction means such as bandbass filters, separating light beams inputted to the photoelectric conversion units with high accuracy, and conducting differential computation.

If a Faraday sensor of closed linear integral type, for example, is used as a Faraday rotator, an incident light beam in a linearly polarized light state is reflected twice at each corner of a sensor and travels through the inside of the sensor so as to circulate around a current to be measured while holding the linearly polarized light state. Irrespective of the relative position of the magneto-optic sensor unit and the electrified conductor, therefore, an output proportionate to the current to be measured is obtained. It is already known by JP-B-2-052827, for example. When the incident light beam is reflected twice at the sensor corner and changed in direction of travel, however, the linearly polarized light becomes elliptically polarized light since the first reflection until the second reflection. There is a possibilitiy that this elliptically polarized light portion becomes an error factor specific to the Faraday sensor of closed linear integral type.

If this Faraday sensor of closed linear integral type is used as the Faraday rotator of the magneto-optic sensor unit, two light beams traveling in mutually opposite directions become elliptically polarized light beams in the same place in the same way. Therefore, an error caused by the elliptically polarized light portion lasting since the first reflection until the second reflection can be compensated together.

Since two beams having the same wavelength characteristics travel through the magneto-optic sensor unit in opposite directions according to the present invention, waveform characteristics of the magneto-optic sensor unit exert no influence. Furthermore, since two light beams are subjected to intensity modulation with mutually different frequencies and electric signals after photoelectric conversion are inputted to band-pass filters to separate the two light beams, leaks of light occurring in the half-mirrors and light branching devices of the optical system exert no influence. Furthermore, since differential computation is conducted to derive a change in quantity of light caused by the Faraday effect, measurements with high accuracy are made possible no matter whether the current to be measured is DC or AC. Especially in the case where a sensor of closed linear integral type is used as the Faraday rotator, errors of the position forming elliptically polarized light can also be compensated and consequently current measurement with the highest accuracy becomes possible.

### BRIEF DESCRIPTION OF THE DRAWINGS

FIG. 1 is an entire configuration diagram of an optical current transformer according to an embodiment of the present invention.

FIG. 2 is a computation processing block diagram of a signal processing circuit shown in FIG. 1.

FIG. 3 shows an optical wavelength spectrum of a light emitting diode used in an embodiment of the present invention, and FIG. 3 is a diagram illustrating an administration criterion of the same wavelength characteristics.

FIG. 4 is a diagram illustrating a driving current waveform of one of light sources shown in FIG. 1.

FIG. 5 is a diagram illustrating a driving current waveform of the other of light sources shown in FIG. 1.

FIG. 6 shows a measured voltage waveform at the output of a photoelectric conversion unit 8 shown in FIG. 2.

FIG. 7 shows a measured voltage waveform at the output of a band-pass filter 12 shown in FIG. 2.

FIG. 8 shows a measured voltage waveform at the output of a photoelectric conversion unit 8' shown in FIG. 2.

FIG. 9 shows a measured voltage waveform at the output of a band-pass filter 12' shown in FIG. 2.

FIG. 10 is a structure diagram of a sensor of closed linear integral type used in an embodiment of the present invention.

FIG. 11 is a diagram illustrating the positional relation between a polarizer 4 and a polarizer 5 shown in the sensor of closed linear integral type of FIG. 10.

FIG. 12 is an example of an exterior view of a magneto-optic sensor.

FIG. 13 shows input-output characteristics of an optical CT measured when the temperature of the optical sensor is low.

FIG. 14 shows input-output characteristics of an optical CT measured when the temperature of the optical sensor is high.

### DESCRIPTION OF THE PREFERRED EMBODIMENTS

Hereafter, an embodiment of the present invention will be described by referring to drawing.

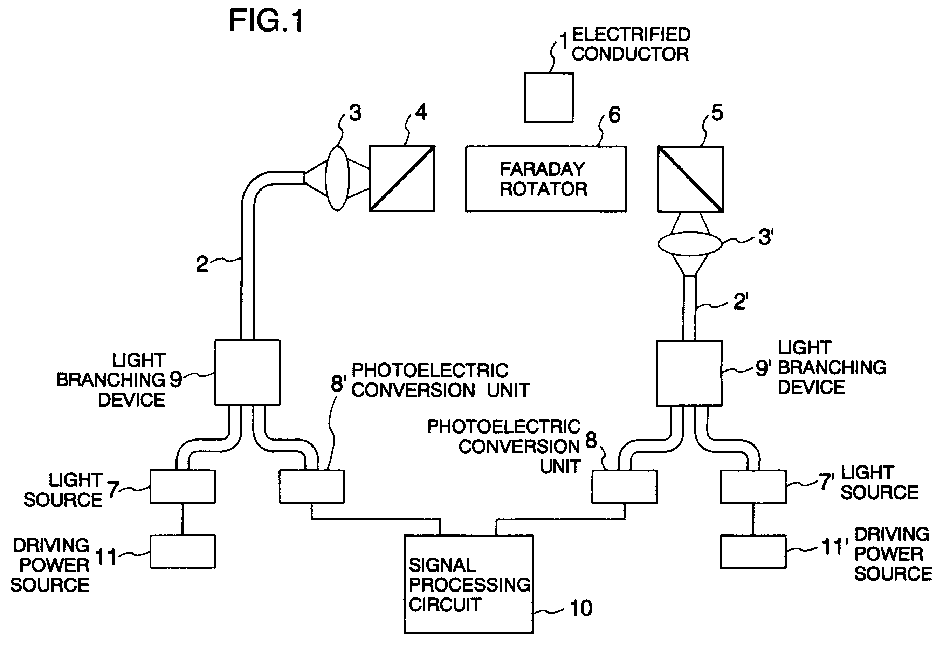

FIG. 1 is an entire configuration diagram of an embodiment of an optical current transformer according to the present invention. In the vicinity of an electrified conductor 1 through which a current to be measured flows, a Faraday rotator 6 is disposed. On both ends of the Faraday rotator 6, two polarizers 4 and 5 having mutually different transmission polarized light directions are disposed. The polarizers 4 and 5 and the Faraday rotator 6 form a magneto-optic sensor unit. Typically, a polarizer of the light incidence side is called "polarizer" and a polarizer of the light exit side is called "analyser." In the present embodiment, however, two light beams travel in mutually opposite directions. In order to avoid confusion, therefore, the polarizers are referred to as "polarizer 4" and "polarizer 5."

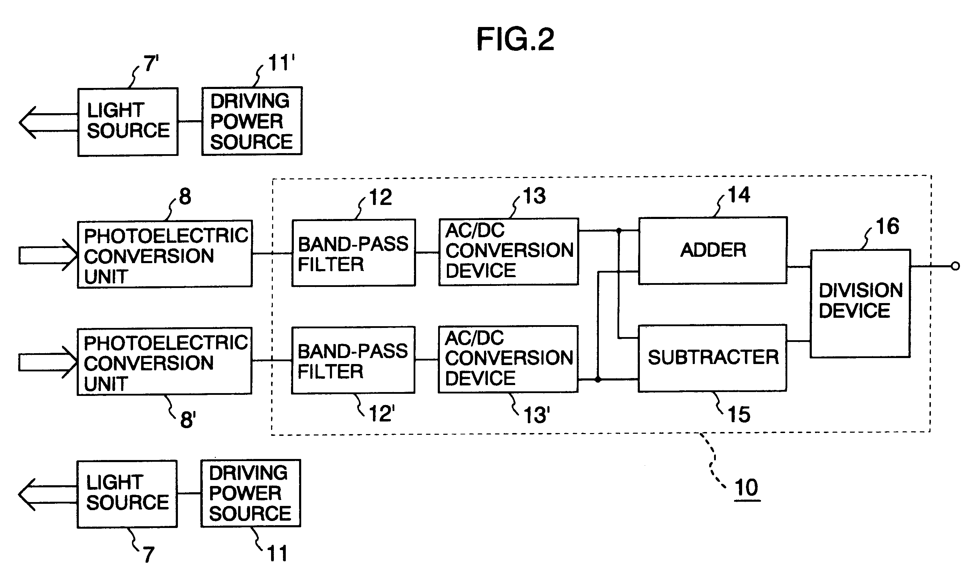

A light source 7 is driven by a power source 11 to emit light. The light beam emitted by the light source 7 is denoted by J1. The light beam J1 is inputted to a light branching device 9, then inputted to the magneto-optic sensor unit via a converging lens 3 and the polarizer 4, and outputted from the polarizer 5. The light beam outputted from the polarizer 5 is inputted to a light branching device 9' via a converging lens 3', and then inputted to a photoelectric conversion unit 8 and a light source 7'. In FIG. 1, 2 and 2' denote optical fibers. The light beam J1 inputted to the photoelectric conversion unit 8 is subjected to a change in quantity of light caused by the Faraday effect while traveling through the magneto-optic sensor unit in such a direction as to proceed from the polarizer 4 to the polarizer 5.

The light source 7' is driven by a power source 11' to emit light. The light beam emitted by the light source 7' is denoted by J2. The light beam J2 is inputted to the light branching device 9', then inputted to the magneto-optic sensor unit via the convergence lens 3' and the polarizer 5, and outputted from the polarizer 4. The light beam J2 outputted from the polarizer 4 is inputted to the light branching device 9 via the convergence lens 3, and then inputted to a photoelectic conversion unit 8' and the light source 7. The light beam J2 inputted to the photoelectric conversion unit 8' is subjected to a change in quantity of light caused by the Faraday effect while traveling through the magneto-optic sensor unit in such a direction as to proceed from the polarizer 5 to the polarizer 4.

The non-reciprocal characteristics of the Faraday effect means that the direction of Faraday rotation is not changed even if the direction of light travel is reversed. If the magneto-optic sensor is formed by disposing the polarizers 4 and 5 so as to rotate the transmission polarized light plane by 45 degrees, the light beams J1 and J2 become mutually perpendicular linearly polarized light beams within the Faraday rotator. As a result, the change rate of quantity of light caused in the light beam J1 by the Faraday effect is identical in quantity, but opposite in polarity to that in the light beam J2 by the Faraday effect.

In the magneto-optic sensor unit and the optical transmission units, the two light beams J1 and J2 travel through an identical path in opposite directions. When the quantity of light is changed by external factors such as a change in temperature and vibration, therefore, the change rate of quantity of light in the light beam J1 is identical both in quantity and in polarity to that in the light beam J2.

If differential computation is conducted on the light beams J1 and J2, therefore, it becomes possible to compensate the change caused in quantity of light by external factors such as a change in temperature and vibration and detect only the change in quantity of light caused by the Faraday effect.

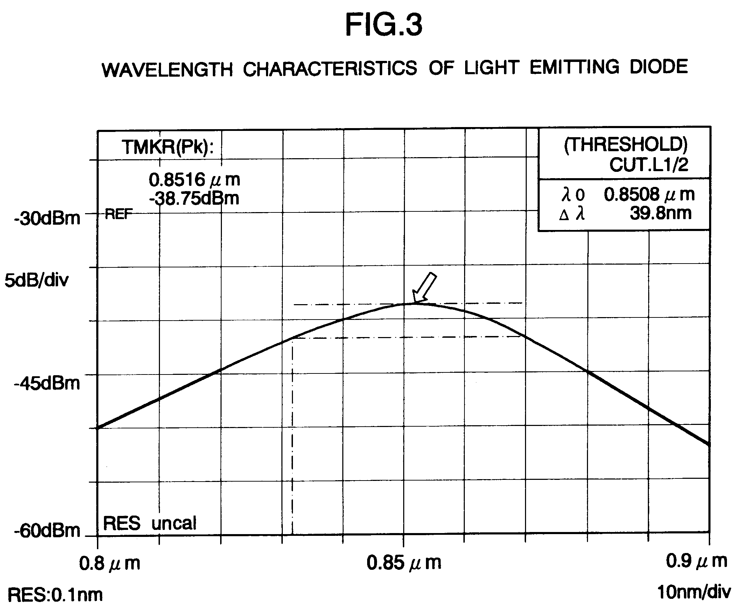

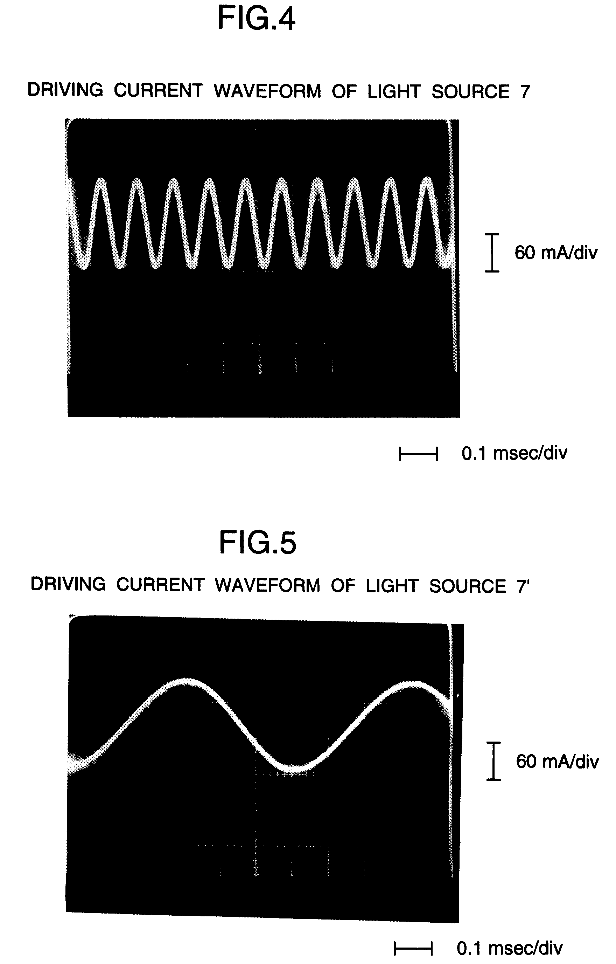

In the present embodiment, the light sources 7 and 7' having the same wavelength characteristics are chosen. An example of wavelength characteristics is shown in FIG. 3. FIG. 3 is a graph showing the optical wavelength spectrum of a light emitting diode sample. Paying attention to central wavelength λp and half-width Δλ, light emitting diodes having the same waveform characteristics in the range of central wavelength of ±0.01 µm and half-width of ±10 nm were selected as the light sources 7 and 7'. FIG. 4 shows a driving current waveform of the light source 7. FIG. 5 shows a driving current waveform of the light source 7'. The light source 7 is driven by a current obtained by a DC current with an AC sine wave of 9.94 kHz (hereafter referred to as frequency f1) superimposed thereon. The light beam thus subjected to intensity modulation with the frequency f1 is the light beam J1. In the same way, the light source 7' is driven by a current obtained by a DC current with an AC sine wave of 1.54 kHz (hereafter referred to as frequency f2) superimposed thereon. The light beam thus subjected to intensity modulation with the frequency f2 is the light beam J2. According to characteristics of band-pass filters which will be described later, frequencies f1 and f2 are determined so that the component of frequency f2 will become 0.1% or less in a band-pass filter passing the frequency f1.

As an example of light quantity measurement in the optical system shown in FIG. 1, the light source 7 (light beam J1) and the light source 7' (light beam J2) are made to emit light singly. Quantities of light (µW) measured at respective portions are shown in Table 1.

**[Table 1]**

| MEASUREMENT EXAMPLE OF QUANTITY LOSS OF LIGHT (TABLE 1) | | | |
|---|---|---|---|
| MEASURING POINT | SINGLE LIGHT EMISSION OF J1 | SINGLE LIGHT EMISSION OF J2 | SIGNAL/NOISE |
| 7∼9 | 162 | 1.9 | |
| 8'∼9 | 0.6 | 1.7 | 1.7/0.6 |
| 3∼4 | 55 | 6.1 | |
| 5∼3' | 5.9 | 56 | |
| 9'∼7' | 1.4 | 209 | |
| 9'∼8 | 1.9 | 0.7 | 1.9/0.7 |

At this time, a sensor of closed linear integral type was used as the Faraday rotator 6 and each light source was driven by a DC current. Measurement was conducted by using an optical power meter. When the light beam J1 was emitted singly, the quantity of light measured between the light source 7 and the light branching device 9 was 162 µW. As the light beam J1 traveled, however, the quantity of light was attenuated. Between the light branching device 9 and the polarizer 4, the quantity of light became 55 µW. Finally, the light beam J1 inputted to the photoelectric conversion unit 8 was 1.9 µW.

On the other hand, the light branching device 9 has a leak of light from the light source 7 to the photoelectric conversion unit 8'. In the sample, the leak was 0.6 µW. Considering it together with a result of measurement conducted when the light beam J2 is emitted singly, the light beam J2 is leaked from the light source 7' as a noise component by 0.6 µW into the photoelectric conversion unit 8 which should detect only the quantity of light (1.9 µW) from the light source 7 (light beam J1). Typically, several percents of 1.9 µW which is the signal component is the change caused in quantity of light by the Faraday effect. For measuring this change in quantity of light with high accuracy, it is necessary to remove the influence of quantity of light corresponding to the noise component.

In the present embodiment, the light beams J1 and J2 are subjected to intensity modulation with sine waves differing in frequency and separated by using the intensity modulation frequencies. FIG. 2 is a computation block diagram of a circuit 10 for conducting this signal processing.

When the light beam J1 intensity-modulated by a sine wave of the frequency f1 is inputted to the photoelectric conversion unit 8 via an optical path, the light beam J1 is converted to an electric signal by the photoelectric conversion unit 8 and then the electric signal is passed through a band-pass filter 12 having the frequency f1 as its center frequency. A DC component and a component of the frequency f2 are thus removed. In the same way, the light beam J2 intensity-modulated by a sine wave of the frequency f2 is converted to an electric signal by the photoelectric conversion unit 8'. Thereafter, the electric signal is passed through a band-pass filter 12' having the frequency f2 as its center frequency. A DC component and a component of the frequency f1 are thus removed.

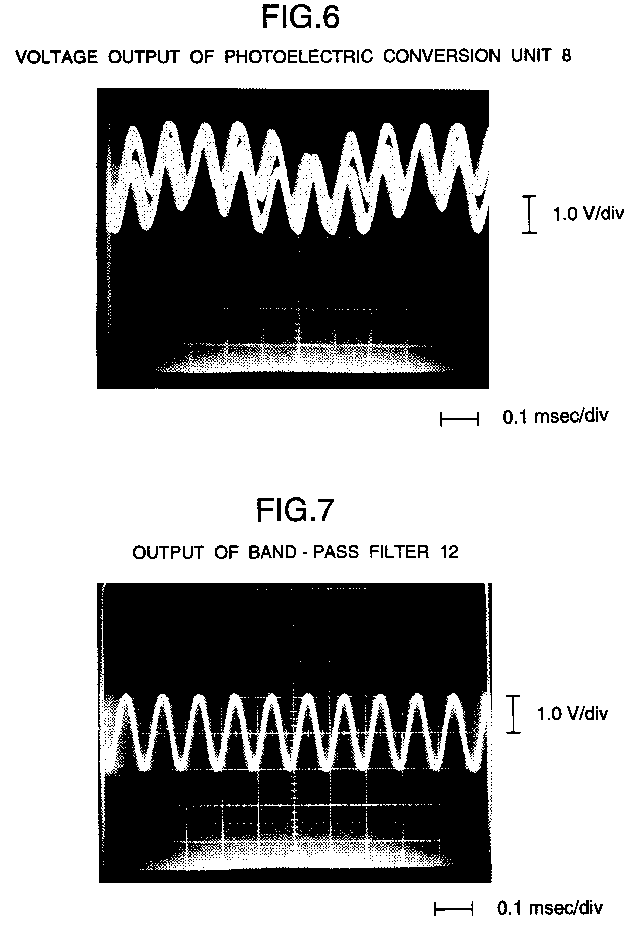

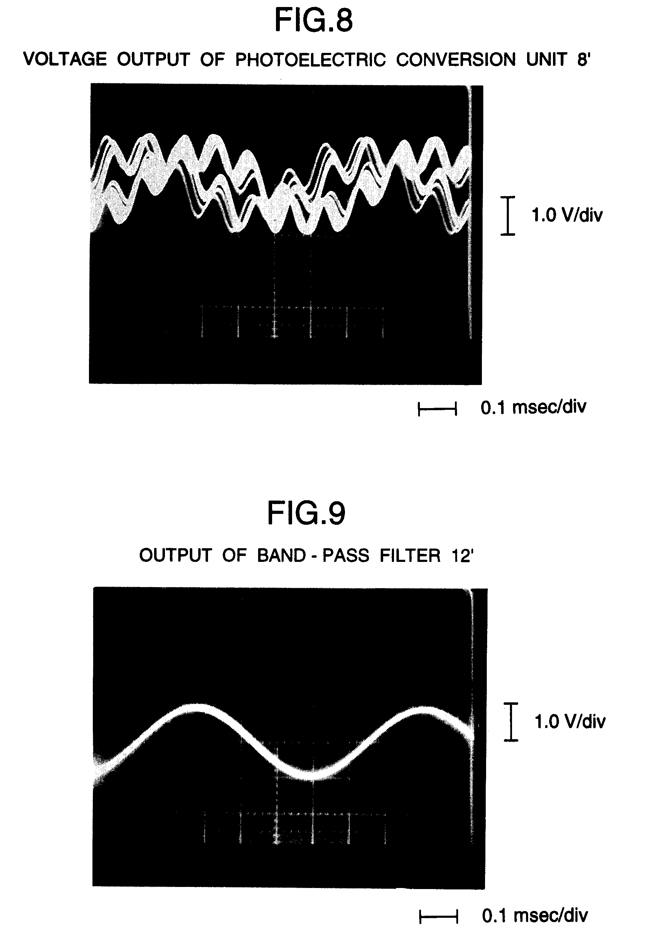

As a measurement example, a voltage waveform outputted from the photoelectric conversion unit 8 is shown in FIG. 6 and a voltage waveform outputted from the band-pass filter 12 is shown in FIG. 7. Furthermore, a voltage waveform outputted from the photoelectric conversion unit 8' is shown in FIG. 8 and a voltage waveform outputted from the band-pass filter 12' is shown in FIG. 9.

From these Figures, it is appreciated that the voltage waveform outputted from a band-pass filter is the same as a sine wave waveform obtained by applying intensity modulation to a light beam and the noise caused by light leak in a light branching device can be removed.

In the signal processing circuit 10, the voltage outputted from the band-pass filter 12 is converted to a DC voltage V1 by an AC/DC conversion device 13. The voltage outputted from the band-pass filter 12' is converted to a DC voltage V2 by an AC/DC conversion device 13'. Thereafter, V1+V2 is derived by an adder 14 and V1-V2 is derived by a subtracter 15. Outputs of the adder 14 and the subtracter 15 are inputted to a division device 16 to derive (V1-V2)/(V1+V2). In the present embodiment, only the change caused in quantity of light by the Faraday effect is detected by the above described differential computation and consequently optical CTs having high accuracy can be realized.

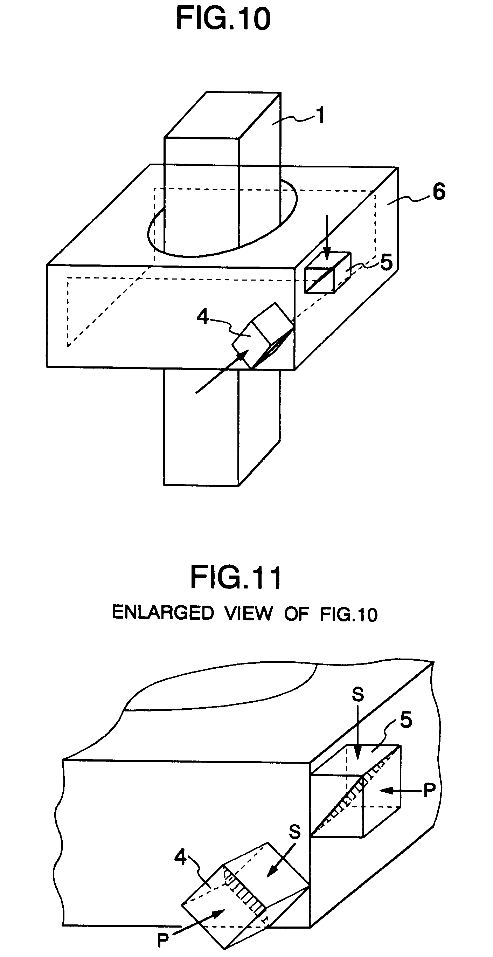

FIG. 10 is a configuration diagram of the megneto-optic sensor unit using a sensor of closed linear integral type as the Faraday rotator 6. FIG. 11 is an enlarged view illustrating the positional relation between the polarizer 4 and the polarizer 5 shown in FIG. 10. In FIG. 11, hatched planes are dielectric multilayer films of the polarizer 4 and the polarizer 5. Their transmission polarized light planes are in positions relatively rotated by 45 degrees.

As for combinations for making mutually perpendicular linearly polarized light travel in opposite directions withing a sensor of closed linear integral type, there are four ways:
P polarized light of the polarizer 4 and P polarized light of the polarizer 5;
P polarized light of the polarizer 4 and S polarized light of the polarizer 5;
S polarized light of the polarizer 4 and P polarized light of the polarizer 5;
S polarized light of the polarizer 4 and S polarized light of the polarizer 5.

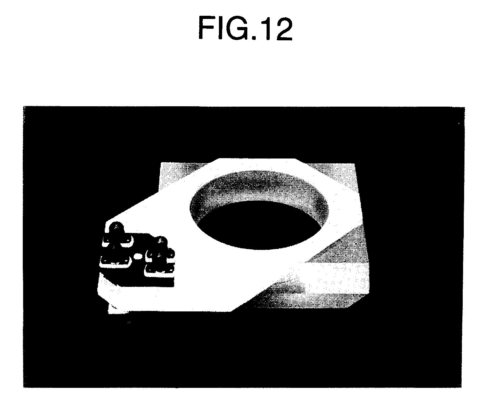

Experiments were conducted on all of the four combinations. As a result, it was found that the combination of P polarized light of the polarizer 4 and S polarized light of the polarizer 5 yielded the least change in quantity of light in response to a temperature change of the magneto-optic sensor unit. This combination is adopted in the following embodiment. FIG. 12 is an exterior view of a magneto-optic sensor which was used in experiments.

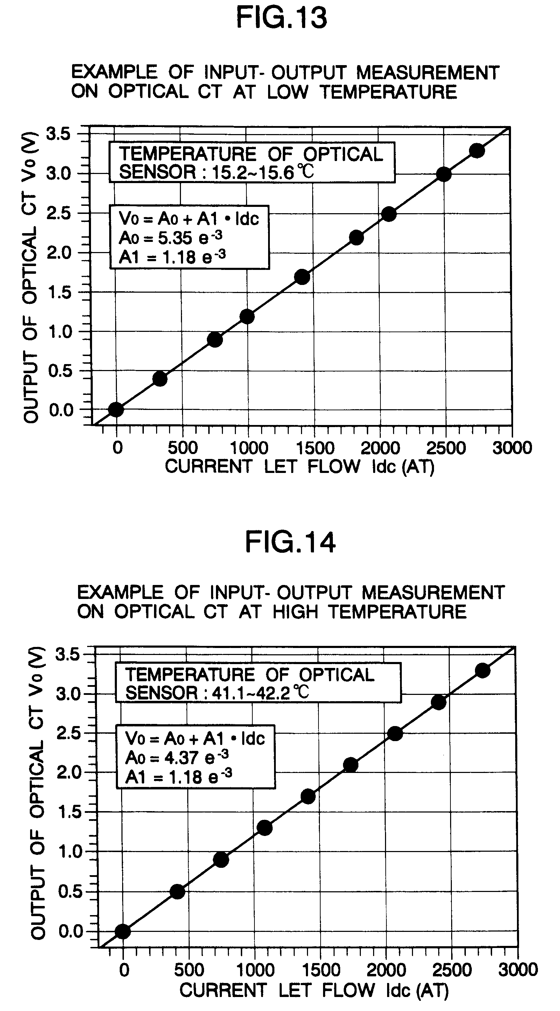

The relation between the current let flow and the output of an optical CT obtained when the atmosphere temperature of the magneto-optic sensor shown in FIG. 12 is varied is shown in FIGs. 13 and 14. From FIGs. 13 and 14, it is appreciated that the input-output characteristics of the optical CT do not change even if there is a temperature change and measurements with high accuracy are conducted. In the present embodiment, the DC current is measured. Even if the measured current is an AC current, however, measurements with high accuracy can be conducted in the same way as the above described embodiment.

## Claims

1. An optical current transformer using the Faraday effect, characterized in that said optical current transformer comprises a magneto-optic sensor unit having a Faraday rotator (6) disposed between two polarizers (4, 5) having mutually different transmission polarized light directions, optical transmission units (2, 2') for inputting light beams to said magneto-optic sensor unit in mutually opposite directions, light source units (7, 7') for generating said input light beams, photoelectric conversion units (8, 8') for sensing output light beams from said magneto-optic sensor unit, and a signal processing circuit (10) for conducting computation processing on electrical signals subjected to photoelectric conversion, and two light sources providing light beams traveling through said magneto-optic sensor unit in mutually opposite directions with same wavelength characteristics are used as said light source units.

2. An optical current transformer using the Faraday effect, characterized in that said optical current transformer comprises a magneto-optic sensor unit having a Faraday rotator (6) disposed between two polarizers (4, 5) having mutually different transmission polarized light directions, optical transmission units (2, 2') for inputting light beams to said magneto-optic sensor unit in mutually opposite directions, light source units (7, 7') for generating said input light beams, photoelectric conversion units (8, 8') for sensing output light beams from said magneto-optic sensor unit, signal processing means (10) for conducting computation processing on electrical signals subjected to photoelectric conversion, means (11, 11') for applying intensity modulation to light beams traveling through said magneto-optic sensor unit in mutually opposite directions by using mutually different frequencies, and extraction (12, 12') for selectively extracting intensity-modulated frequency components from said electric signals subjected to photoelectric conversion and making said signal processing means conduct computation processing.

3. An optical current transformer using the Faraday effect, characterized in that said optical current transformer comprises a magneto-optic sensor unit having a Faraday rotator (6) disposed between two polarizers (4, 5) having mutually different transmission polarized light directions, optical transmission units (2, 2') for inputting light beams to said magneto-optic sensor unit in mutually opposite directions, light source units (7, 7') for generating said input light beams, photoelectric conversion units (8, 8') for sensing output light beams from said magneto-optic sensor unit, and signal processing means (10) for conducting computation processing on electrical signals subjected to photoelectric conversion, and said signal processing means comprises means (14, 15, 16) for conducting differential computation to derive a change of quantity of light caused by the Faraday effect in two beams traveling through said magneto-optic sensor unit in mutually opposite directions.

4. An optical current transformer using the Faraday effect, characterized in that said optical current transformer comprises a magneto-optic sensor unit having a Faraday rotator (6) disposed between two polarizers (4, 5) having mutually different transmission polarized light directions, optical transmission units (2, 2') for inputting light beams to said magneto-optic sensor unit in mutually opposite directions, light source units (7, 7') for generating said input light beams, said light source having two light sources providing light beams traveling through said magneto-optic sensor unit in mutually opposite directions with same wavelength characteristics, photoelectric conversion units (8, 8') for sensing output light beams from said magneto-optic sensor unit, signal processing means (10) for conducting computation processing on electrical signals subjected to photoelectric conversion, means (11, 11') for applying intensity modulation to light beams traveling through said magneto-optic sensor unit in mutually opposite directions by using mutually different frequencies, and extraction means (12, 12') for selectively extracting intensity-modulated frequency components from said electric signals subjected to photoelectric conversion and making said signal processing means conduct computation processing, and said signal processing means (10) comprises means (14, 15, 16) for conducting differential computation to derive a change of quantity of light caused by the Faraday effect in two beams traveling through said magneto-optic sensor unit in mutually opposite directions.

5. An optical current transformer according to any one of Claims 1 to 4, characterized in that a Faraday sensor of closed linear integral type is used as a Faraday rotator.
